# EUROPÄISCHE PATENTSCHRIFT

(11) **EP 2 472 752 B1**
(45) Veröffentlichungstag und Bekanntmachung des Hinweises auf die Patenterteilung: **21.02.2018**
(21) Anmeldenummer: 11194999.6
(22) Anmeldetag: 21.12.2011
(51) Int. Cl.: H04H 40/18, H04H 60/23, H04H 60/41, H04H 20/26, H04H 60/43

(54) **FERNSEHEMPFANGSGERÄT**
Television reception device
Appareil de réception de télévision

(30) Priorität: 28.12.2010 DE 102010061608
(43) Veröffentlichungstag der Anmeldung: 04.07.2012
(73) Patentinhaber: LOEWE Technologies GmbH, 96317 Kronach (DE)
(72) Erfinder: Weickert, Bernd, 96224 Burgkunstadt (DE)

(56) Entgegenhaltungen:
- EP-A1- 1 361 759
- EP-A2- 1 463 320
- EP-A2- 2 091 243
- WO-A1-95/31069
- WO-A1-2008/007045
- DE-B3- 10 238 330
- US-A1- 2002 080 160
- US-A1- 2005 090 235
- US-A1- 2010 060 786

## Beschreibung

Die vorliegende Erfindung betrifft ein Rundfunksignalempfangsgerät mit den Merkmalen des Oberbegriffs des Patentanspruches 1.

Digitale Rundfunksysteme ermöglichen es, dass Video- und Audiosignale bzw. digitale Fernsehsignale nach dem MPEG-Verfahren paketweise in bestimmten Datenformaten übertragen werden. Mittels dieses Verfahrens können Programmbeiträge bestimmter Programme von Sendeanstalten übertragen werden. Es können aber auch diverse andere Dienste in gleicher Weise unverschlüsselt aber auch verschlüsselt übertragen werden, so dass im Falle der verschlüsselten Übertragung nur Berechtigte mit ihrem digitalen Empfänger den jeweiligen Dienst nutzen können. Verschiedene Dienstanbieter verwenden eigene Verschlüsselungsnormen, so genannte Conditional Access-Systeme, um ihr Video- und Audioangebot nur Nutzungsberechtigten zur Verfügung zu stellen. Innerhalb Europas verwenden die Dienstanbieter verschiedene CA-Systeme. Die bekanntesten sind unter den Namen IrDeto, BetaCrypt, SECNMediaguard, Viaccess, Nagra, Conax, Videoguard, Cryptoworks bekannt. Die Dienstanbieter weisen mindestens in einem der übersandten Blöcke durch eine so genannte CA-System-ID (Conditional Access-Systems-Identifier) auf die gewählte Verschlüsselungsnorm hin. Dies geschieht durch Übertragung des CA-System-Identifiers in einem Datenblock, der von einem Decoder mit Descrambler im Empfangsgerät auswertbar ist und zur Identifizierung und Entschlüsselung herangezogen wird. Der Decoder bzw. das Modul, das als Entschlüsseler im Endgerät eingesetzt ist, enthält ebenfalls diesen dienstanbieterspezifischen CA-System-Identifier, um eine Selektion der zugeordneten Datenpakete überhaupt vornehmen und um eine Entschlüsselung der verschlüsselten Daten über den Decoder bewerkstelligen zu können, damit die entschlüsselten Daten, z.B. Video- und/oder Audiodaten, weiterverarbeitbar und wiedergebbar sind. Jeder Dienstanbieter kann unter Verwendung des von ihm verwendeten Schlüssels eine Vielzahl von Diensten anbieten.

Aus der DE 40 34 493A1 ist eine Vorrichtung zur Senderprogrammierung eines Satellitenfernsehempfängers bekannt, die eine Bedieneinheit, einen Satellitentuner, eine Steuerschaltung und einen Satellitensenderspeicher aufweist. Zur Vereinfachung der Senderprogrammierung wird vorgeschlagen, den Satellitenempfänger zusätzlich mit einem Benutzerführungsinformationsspeicher und einem Satellitenparameterspeicher auszurüsten. Der Satellitenparameterspeicher wird bereits bei der Herstellung des Satellitenempfängers mit Satellitenparametern einer Vielzahl von Satelliten gefüllt. Bei der Senderprogrammierung werden die Parameter sämtlicher Programme eines gewünschten Satelliten auf einem Bildschirm dargestellt. In dieser Darstellung werden die Parameter eines gewünschten Programms mittels der Bedieneinrichtung angewählt und durch Betätigung einer Bestätigungstaste der Bedieneinrichtung in den Satellitensenderspeicher übernommen. Das Auswahlprogramm enthält dabei ebenfalls eine Aufforderung zur Eingabe, ob ein Descrambler angeschlossen oder nicht vorhanden ist. Der Benutzer muss dies jeweils durch eine Antwort "Ja" oder "Nein" bestätigen, so dass auch verschlüsselte Programme empfangen und dargeboten werden können. Dieses Programm gibt eine benutzerführungsunterstützte manuelle Auswahlmöglichkeit zwischen vorab gespeicherten Satellitenprogrammen an. Es ist weder ein automatischer Suchlauf noch eine automatische Programmplatzzuordnung möglich.

Aus der DE 198 15 952A1 ist ein Verfahren zur Belegung des Senderspeichers eines Rundfunkempfängers und/oder Datenempfängers bekannt, bei dem zunächst ein Sendersuchlauf durchgeführt wird, um eine Sendersuchlauftabelle zu generieren, in der Daten einer Vielzahl von ausgestrahlten Sendern enthalten sind. Es erfolgt ein Vergleich der Sendersuchlauftabelle mit einer im Rundfunkempfänger abgespeicherten benutzerspezifischen Sendertabelle zur Ermittlung von Sendern, die sowohl der Sendersuchlauftabelle als auch der benutzerspezifischen Sendertabelle angehören. Die Daten der bei diesem Vergleich ermittelten Sender werden im nichtflüchtigen Senderspeicher des Rundfunkempfängers abgelegt. Beim Suchlauf werden dabei auch Sender mit erfasst, die verschlüsselte Programme enthalten können, gleich ob nun diese Programme mit einem im Gerät vorhandenen Decoder decodiert werden können oder nicht. Dies führt zu einer Programmauflistung, die nicht empfangbare Sender mit auflistet.

Aus der Fachzeitschrift RFE, Nr. 9/1998, Seiten 28 bis 31, ist die Architektur eines digitalen Satellitenreceivers bekannt, der eine Schnittstelle für Chipkarten aufweist, auf denen Entschlüsselungsalgorithmen enthalten sind, um empfangene Signale decodieren zu können. Die dabei zur Anwendung kommenden üblichen CA-Systeme sind die eingangs beschriebenen CA-Systeme verschiedener Dienstanbieter.

Aus der DE 197 27 564 C1 ist ein Verfahren zum Belegen von Programmplätzen mit Kanälen von empfangbaren Sendern in Tunereinrichtungen bekannt, bei dem manuell oder mittels eines automatischen Abstimmsystems, einer Speichereinrichtung und einer Steuereinrichtung die Kanäle der empfangbaren Sender abgesucht und der Reihe nach auf Programmplätzen gespeichert werden und die Zuordnung der Kanalnummern zu den Programmplätzen veränderbar ist. So ist es möglich, eine erste gespeicherte Kanalnummer auf einen eingestellten, mit einer zweiten Kanalnummer belegten Programmplatz zu wechseln, indem ein Austauschsignal erzeugt wird, durch das die Steuereinrichtung veranlasst wird, erste Kanalnummern durch zweite Kanalnummern bezüglich der belegten Programmplätze auszutauschen (Austauschmodus) und in der Speichereinrichtung einzuspeichern oder die Programmplatzbelegung und alle weiteren in Aufwärtsrichtung zu verschieben (Einfügemodus), wenn eine zweite Nummer in einen Programmplatz eingefügt wird, wobei die Programmplätze, die zugeordneten Kanalnummern und/oder die Bezeichnungen der Sendeanstalten auf einem Bildschirm listenmäßig dargestellt werden. Durch wahlfreie Markierung werden Programmplätze fortlaufend umsortiert oder zu Gruppen zusammengestellt und an ausgewählten Plätzen eingefügt oder Gruppen ausgetauscht. Um ein Programm anzuwählen, kann sodann aus der Tabelle mittels Cursor-Führung ein Programm ausgewählt werden. Auf dieses Programm wird sodann abgestimmt. Die entsprechenden Abstimmparameter sind in einem Speicher gespeichert. Die Liste kann durch einen elektronischen Suchlauf erstellt werden, eine bereits vorhandene Liste kann durch neu hinzugetretene Programme ergänzt werden, indem ein erneuter Suchlauf gestartet wird. Vor dem Start kann eingegeben werden, dass nur neue, noch nicht abgespeicherte Programme aufgenommen werden sollen.

Aus DE 102 38 330 B3 ist ein Verfahren zum Belegen von Speicherplätzen mit Kanälen von empfangbaren, verschlüsselt übertragenen Diensten verschiedener Dienstanbieter in einer Tunereinrichtung eines Empfangsgeräts bekannt. Bei diesem Empfangsgerät sind manuell oder mittels eines automatischen Abstimmsystems die Kanäle der empfangbaren Dienste absuchbar und der Reihe nach oder auf vorgegebene Speicherplätze speicherbar. Die Steuereinrichtung erfasst, ob ein Decoder zum Dekodieren von verschlüsselten Dienstbeiträgen im Empfangsgerät und/oder ein vom Decoder abgegebenes oder auslesbares Datum oder ein anderes Signal vorhanden ist, das den Decoder als Entschlüsseler für bestimmte Dienste identifiziert. Die Steuereinrichtung speichert die Abstimmdaten des bestimmten Dienstes nur dann im Speicher ab, wenn die Identifizierung des Dienstes erfolgt ist.

Aus DE 102 38 330 B3 ist ein Verfahren zum Belegen von Speicherplätzen mit Kanälen von empfangbaren, verschlüsselt übertragenen Diensten verschiedener Dienstanbieter in einer Tunereinrichtung in einem Empfangsgerät bekannt. Das Empfangsgerät kann manuell oder mittels automatischem Abstimmsystem die Empfangskanäle absuchen und der Reihe nach oder auf vorgegebene Programmplätze speichern. Zusätzlich wird erfasst, ob ein Decoder zum Dekodieren von verschlüsselten Dienstbeiträgen im Empfangsgerät vorhanden ist und eine Abstimmung eines Dienstes nur dann im Speicher erfolgt, wenn die Identifizierung des Dienstes erfolgt ist. Hierzu ist aber stets eine vollständige Decodierung des verschlüsselten Dienstbeitrages notwendig.

US 2010/0060786 A1 offenbart ein Verfahren und eine Vorrichtung für einen Sendersuchlauf. Hierbei sind ein vollständiger Sendersuchlauf und ein partieller Sendersuchlauf möglich. Verschlüsselte Sender oder Programme werden in US 2010/0060786 A1 angesprochen. Aufgabe von US 2010/0060786 A1 ist es, weitere nicht bereits abgespeicherte Sender zu finden.

WO 95/31069 offenbart u. a. ein Verfahren und System zur Übertragung von Fernsehinformationen, wobei Informationen zu regionalen Datenverarbeitungssystemen übertragen werden und von den regionalen Datenverarbeitungssystemen die Informationen an eine Vielzahl von Abonnentendatenverarbeitungssystemen übertragen werden, wobei die Abonnentendatenverarbeitungssysteme spezifische regionale Informationen erhalten. Diese werden in Tabellen gespeichert, die in Abhängigkeit von der Verfügbarkeit der Information in der Datenbasis aktualisiert werden, wobei Einträge gelöscht werden können.

Nachteilig beim bekannten Stand der Technik ist, dass die eingangs genannten und bekannten Verfahren und Geräte stets mindestens einen vollständigen Decodierversuch benötigen, um zu erkennen, ob eine Entschlüsselung oder Decodierung von verschlüsselt übertragenen Diensten oder Rundfunkprogrammen erfolgen kann. Dies hat zur Folge, dass ein Sendersuchlauf lange Zeit in Anspruch nimmt, wenn viele verschlüsselte Sender empfangbar sind, da zunächst jeder empfangene Sender komplett decodiert werden muss, ehe eine Speicherung erfolgt. Außerdem muss im Laufe der Zeit ein Sendersuchlauf erneut vorgenommen werden, wenn zum einen der Nutzer neue Rechte für die Entschlüsselung erworben hat oder wenn neue Sender hinzukommen oder sich der Ort der Bereitstellung der Sender oder sich der Ort der Aufstellung des Gerätes verändert hat.

Ziel der vorliegenden Erfindung ist es, ein Rundfunksignalempfangsgerät aufzuzeigen, das ein effizientes Verfahren zur Verwaltung von Sendern, verschlüsselt oder unverschlüsselt verwendet, und zwar unabhängig davon, ob diese Sender vom Rundfunksignalempfangsgerät decodierbar oder nicht decodierbar sind,.

Diese Aufgabe wird anhand der Merkmale des Patentanspruchs 1 gelöst. Vorteilhafte Ausgestaltungen der Erfindung ergeben sich anhand der Merkmale der abhängigen Patentansprüche, sowie der weiteren Beschreibung, insbesondere anhand der Beschreibung eines konkreten Ausführungsbeispiels anhand einer Figur.

Das erfindungsgemäße Rundfunksignalempfangsgerät weist mindestens einen Tuner oder eine Empfangseinrichtung oder Empfangseinheit und mindestens eine Steuereinheit auf, wobei das Rundfunksignalempfangsgerät mittels der Steuereinheit in mindestens zwei Sendersuchlaufbetriebsarten betreibbar ist. In der ersten Sendersuchlaufbetriebsart sucht das Rundfunksignalempfangsgerät automatisch nacheinander alle selektiv vom Rundfunksignalempfangsgerät empfangbaren verschlüsselten und unverschlüsselten Rundfunksignalsender mittels des mindestens einen Tuners, gesteuert von der mindestens einen Steuereinheit, ab und speichert Informationen über alle verschlüsselten und unverschlüsselten vom Rundfunksignalempfangsgerät empfangbaren Rundfunksignalsender in einem Senderspeicher des Rundfunksignalempfangsgeräts ab. In der mindestens zweiten Sendersuchlaufbetriebsart sucht das Rundfunksignalempfangsgerät automatisch nacheinander alle selektiv von dem Rundfunksignalempfangsgerät empfangbaren verschlüsselten und unverschlüsselten Rundfunksignalsender mittels des mindestens einen Tuners, gesteuert von der mindestens einen Steuereinheit, ab und vergleicht die Informationen über alle verschlüsselten und unverschlüsselten vom Rundfunksignalempfangsgerät empfangbaren Rundfunksignalsender mit den bereits im Senderspeicher gespeicherten Rundfunksignalsendern und speichert nur nicht bereits im Senderspeicher vorhandene Rundfunksignalsender nach dem letztbelegten Senderspeicherplatz im Senderspeicher ein. Außerdem ist im Rundfunksignalempfangsgerät mindestens ein Decoder zur Decodierung verschlüsselt übertragener Rundfunksignalsender bzw. -inhalte oder -programmbeiträge vorhanden. Beim Betrieb der ersten und der mindestens zweiten Sendersuchlaufbetriebsart untersucht das Rundfunksignalempfangsgerät, gesteuert über die Steuereinheit, beim Auffinden eines verschlüsselten Rundfunksignalsenders die übertragenen Daten mittels des mindestens einen Decoders, ob diese vom mindestens einen Decoder dekodierbar sind, wobei das Rundfunksignalempfangsgerät hierzu Zusatzdaten verwendet, die vom Rundfunksignalsender mit übertragen werden. Im Falle der erfolgreichen Dekodierung belässt das Rundfunksignalempfangsgerät die im Senderspeicher gespeicherten Daten zum Rundfunksignalsender unverändert, jedoch bei erfolgloser Dekodierung dieses Rundfunksignalsenders markiert das Rundfunksignalempfangsgerät im Senderspeicher diese Rundfunksignalsender als nicht entschlüsselbar oder löscht diese Rundfunksignalsender aus dem Senderspeicher.

Ein Rundfunksignalempfangsgerät im Sinne der Erfindung ist ein Gerät der Unterhaltungselektronik, insbesondere ein TV-Gerät, ein Satellitenreceiver, ein DVB-Empfänger, ein DVB-T-Empfänger, ein Gerät zur Nutzung von via Internet bereitgestellten Audio-/ und/oder Videodaten oder eine Kombination der vorgenannten Geräte.

Ein Tuner im Sinne der vorliegenden Erfindung ist eine Vorrichtung mittels derer über Empfangskanäle Rundfunksender und/oder Rundfunksendungen empfangbar sind. Unter den Begriff der Empfangskanäle fallen Transponder und in einem Transponder bzw. mit einem Transponder übertragene Rundfunksignale und Rundfunksendungen, ebenso terrestrische Frequenzen zur Übertragung von Programminhalten, wie auch via Internet bereitgestellte Programminhalte, auch als "Content" bezeichnet.

Eine Steuereinheit im Sinne der Erfindung ist eine Mikrocomputereinheit, ein Mikrocomputer, ein Mikrocontroller, eine Mikrocontrollereinheit oder jede weitere elektronische Einheit, welche Funktionen eines elektrischen und/oder elektronischen Gerätes regelt oder steuert.

Vorteilhaft nach Patentanspruch 2 ist, dass das Rundfunksignalempfangsgerät mittels der Steuereinheit und des mindestens einen Decoders zur Decodierung die Überprüfung der Entschlüsselbarkeit der vom Rundfunksignalsender übertragenen Informationen erst nach Beendigung eines Sendersuchlaufs vornimmt. Hierdurch wird der Sendersuchlauf nicht durch einen Überprüfungsvorgang der Decodierbarkeit einer verschlüsselt übertragenen Rundfunksignalsendung verzögert. Der Sendersuchlauf ist auf das Auffinden von Sendern und Programminhalten beschränkt.

Vorteilhaft nach Patentanspruch 3 ist, dass auf einer dem Rundfunksignalempfangsgerät zugeordneten Darstellungseinheit die im Senderspeicher gespeicherten Rundfunksignalsender in Form einer Rundfunksignalsenderliste darstellbar sind und die nicht als entschlüsselbar markierten Rundfunksignalsender mit einer entsprechenden Markierung versehen dargestellt sind oder die als nicht entschlüsselbar markierten Rundfunksignalsender nicht in der Rundfunksignalsenderliste darstellbar sind. Einem Benutzer werden damit nur die Rundfunksender auf der Darstellungseinheit angezeigt, die er auch tatsächlich nutzen kann. In der alternativen Ausführung wird Speicherplatz gespart, da nur tatsächlich nutzbare Rundfunksignalsender im Senderspeicher gespeichert werden.

Eine Darstellungseinheit im Sinne der Erfindung ist in einer vorteilhaften Ausgestaltung der Erfindung ein Bildschirm oder ein Display.

Vorteilhaft nach Patentanspruch 4 ist, dass das Rundfunksignalempfangsgerät mittels der Steuereinheit die als nicht entschlüsselbar markierten Rundfunksignalsender am Ende der Senderliste darstellt und/oder den Senderspeicher in der Weise sortiert, dass die als nicht entschlüsselbar markierten Rundfunksignalsender nach den nicht verschlüsselten oder als entschlüsselbar markierten Rundfunksignalsendern angefügt sind. Dies hat den Vorteil, dass auf den vorderen Plätzen des Senderspeichers nur Rundfunksignalsender angeordnet sind, welche auch tatsächlich für einen Nutzer nutzbar sind.

Vorteilhaft nach Patentanspruch 5 ist, dass das Rundfunksignalempfangsgerät bei Erkennung einer Veränderung am Decoder zur Decodierung oder bei Erkennung von Änderungen der Decodierungsrechte des Decoders zur Decodierung oder bei Erkennen eines Einbaus oder neuen Vorhandenseins eines weiteren Decoders zur Decodierung einen Sendersuchlauf startet. Hierdurch wird der Senderspeicher stets auf den aktuellen Stand der vom Rundfunksignalempfangsgerät empfangbaren und nutzbaren Rundfunksignalsender gehalten. Außerdem erfolgt dies automatisch, ohne dass der Nutzer eingreifen muss.

Vorteilhaft nach Patentanspruch 6 ist, dass das Rundfunksignalempfangsgerät bei Erkennung einer Veränderung am Decoder zur Decodierung oder bei Erkennung von Änderungen der Decodierungsrechte des Decoders zur Decodierung oder bei Erkennen eines Einbaus oder Vorhandenseins eines weiteren Decoders zur Decodierung alle bereits im Senderspeicher gespeicherten und verschlüsselt und/oder als nicht entschlüsselbar markierten Rundfunksignalsender erneut versucht zu dekodieren und in Abhängigkeit des Ergebnisses des Dekodierversuchs die Markierung der Rundfunksignalsender unverändert belässt oder verändert. Hierdurch wird der Senderspeicher stets auf den aktuellen Stand der vom Rundfunksignalempfangsgerät empfangbaren und für einen Nutzer tatsächlich nutzbaren Rundfunksignalsender gehalten, ohne dass ein Sendersuchlauf vorgenommen werden muss. Es werden die bereits mittels eines früheren Sendersuchlaufs im Senderspeicher gespeicherten Rundfunksignalsender untersucht und entsprechend umgruppiert. Außerdem erfolgt dies automatisch, ohne dass der Nutzer eingreifen muss.

Vorteilhaft nach Patentanspruch 7 ist, dass das Rundfunksignalempfangsgerät zur Erkennung, ob Informationen, die von einem verschlüsselt übertragenen Rundfunksignalsender übertragen werden, von dem Decoder zur Decodierung entschlüsselbar sind, die Zusatzdaten verwendet, die vom Rundfunksignalsender bereitgestellt sind. Hierdurch ist eine schnelle Überprüfung möglich. Es muss nicht erst ein vollständiger Versuch einer Decodierung eines Rundfunksignalsenders vorgenommen werden, es genügt eine Überprüfung anhand der Zusatzdaten.

In einer vorteilhaften Ausgestaltung der Erfindung nach Patentanspruch 8 ist vorgesehen, dass der Decoder ein embedded Conditional-Access-Modul ist.

In einer vorteilhaften Ausgestaltung der Erfindung nach Patentanspruch 9 ist vorgesehen, dass das Common-Interface-Conditional-Access-Modul, das die Entschlüsselung der verschlüsselt übertragenen Informationen eines Rundfunksignalsenders vornimmt, mit einer in das Rundfunksignalempfangsgerät über einen Eingabeschacht einfügbaren Smartcard kommuniziert und/oder die Überprüfung der Entschlüsselbarkeit der von einem Rundfunksignalsender übertragenen Informationen zu einer vom Benutzer des Rundfunksignalempfangsgeräts über ein Menü, darstellbar auf der Darstellungseinheit des Rundfunksignalempfangsgeräts, einstellbaren Zeit erfolgt und/oder die Überprüfung der Entschlüsselbarkeit der von einem Rundfunksignalsender übertragenen Informationen vorzugsweise während des Nichtbetriebes des Rundfunksignalempfangsgeräts durch einen Nutzer erfolgt.

Eine Smartcard im Sinne der Erfindung ist jede Chipkarte oder sonstige elektronische Einheit, auf der Entschlüsselungsalgorithmen oder Kenndaten oder Kennworte für die Entschlüsselung oder Decodierung eines verschlüsselt übertragenen Senders oder -inhalts oder -programmbeitrags vorhanden sind.

Im Nachfolgenden wird die Erfindung anhand eines konkreten Ausführungsbeispiels anhand einer Figur näher erläutert. Die Beschreibung der Erfindung anhand des nachfolgenden konkreten Ausführungsbeispiels stellt keine Limitierung der Erfindung auf dieses Ausführungsbeispiel dar.

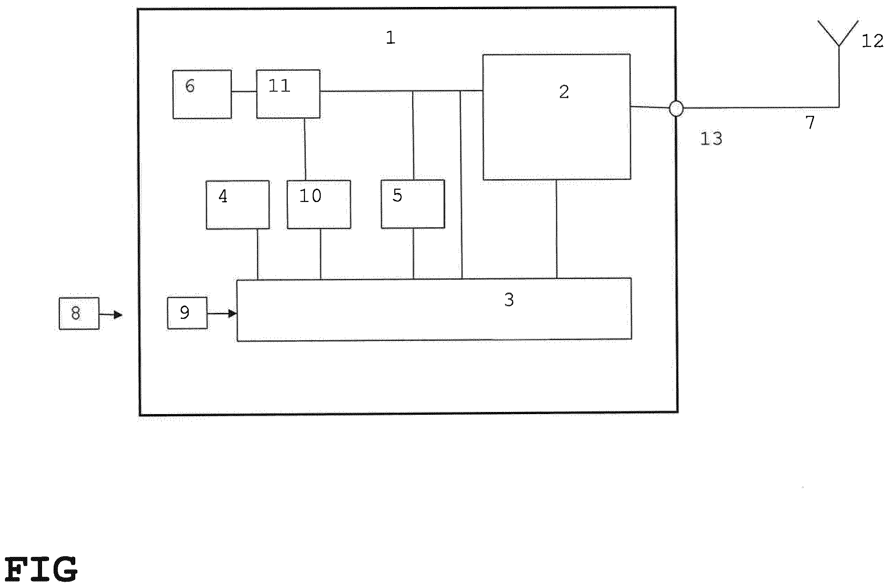

Die einzige Figur zeigt einen schematischen Aufbau eines erfindungsgemäßen Rundfunksignalempfangsgeräts.

In der Figur ist der schematische Aufbau eines erfindungsgemäßen Rundfunksignalempfangsgeräts anhand eines TV-Gerätes 1 dargestellt.

Das TV-Gerät 1 ist mit einer Empfangseinheit 2, welche im Weiteren als Tuner bezeichnet wird, ausgestattet. Der Tuner 2 dient dazu über einen Eingang 13, der mit einer Signalbereitstellungseinheit 12 verbunden ist, welche in der Figur FIG als Satellitensignalempfangsantenne ausgeführt ist und somit vorzugsweise HF-Signale am Eingang 13 bereitstellt, Signale von Sendern mit Sendeinhalten zu erfassen und zur Darstellung auf dem Bildschirm 6 des TV-Gerätes 1 aufzubereiten.

Heutzutage erfolgt die Übertragung solcher Rundfunkempfangssignale z.B. nach dem DVB-Standard.

In einer weiteren Ausgestaltung der Erfindung ist vorgesehen, dass der Tuner 2 für sämtliche Arten von Rundfunksignalen geeignet ist, so auch für internetbasierende und via Internet übertragene Sendebeiträge oder Programminhalte, terrestrisch übertragene Sender oder Sendebeiträge oder Programminhalte, die z.B. den DVB-T-Standard benutzen.

Der Tuner 2 ist dazu geeignet, DVB-Signale, die in DVB-Netzen (Digital Video Broadcasting) oder nach dem DVB-Standard übertragen werden und welche Sendeinhalte enthalten, zu empfangen. In solchen DVB-Netzen werden zum Teil auch Sendungen, Programmbeiträge bzw. Rundfunksignalsendungen bereitgestellt, welche entweder direkt umsetzbar sind, d.h. ohne eine Entschlüsselung, oder aber auch verschlüsselt übertragen werden, so dass die Darstellung auf dem Bildschirm 6 des TV-Gerätes 1 nur möglich ist, wenn ein Decoder 5 im Gerät vorhanden ist, der die verschlüsselten Programminhalte decodieren kann. Ein solches Entschlüsselungsverfahren ist das so genannte CSA-Verfahren (Common Scrambling Algorithm). Das TV-Gerät 1 benötigt zum Entschlüsseln dieses verschlüsselt übertragenen Programmbeitrags ein Kontrollwort, mittels dessen der Decoder 5 den Programmbeitrag decodieren und dem TV-Gerät 1 zur Darstellung auf dem Bildschirm 6 über die Darstellungsaufbereitungseinheit 11 zur Verfügung stellt. Hierzu wird der vom Tuner 2 empfangene verschlüsselte Datenstrom des empfangenen Senders von der Mikrocomputereinheit 3 über den Decoder 5 geleitet. Der Decoder 5 decodiert oder entschlüsselt dann den Datenstrom.

Um das TV-Gerät 1 in die Lage zu versetzen, ein decodiert übertragenes Rundfunksignal zu verarbeiten und mit dem Decoder 5 den übertragenen Sendeinhalt oder Programmbeitrag zu decodieren, überträgt der Anbieter bzw. Sender des verschlüsselt übertragenen Sendeinhalts oder Programmbeitrags zusätzliche Datenpakete, so genannte ECMs (Entitled Control Messages). Mittels einer Smartcard oder einer direkt im TV-Gerät 1 angeordneten Decodereinheit (in der Figur ist allgemein nur von dem Decoder 5 die Rede) errechnet dann das TV-Gerät 1 bzw. die Mikrocomputereinheit 3, auch als Steuereinheit des TV-Geräts 1 bezeichenbar, oder alternativ der Decoder 5 ein Kontrollwort. Dieses Kontrollwort dient dann zur Entschlüsselung des Sendeinhalts oder Programmbeitrags mittels des Decoders 5. Anhand des Kontrollworts kann die Mikrocomputereinheit 3 über die im TV-Gerät 1 über einen sogenannten SmartCard-Reader eingefügte Smartcard oder aber anhand direkt im Decoder 5 abgespeicherten Daten erkennen, ob ein verschlüsselt übertragener Sendeinhalt oder Programmbeitrag vom Decoder 5 entschlüsselbar ist.

Auf der Smartcard sind Daten gespeichert, welche die Nutzungsrechte des Nutzers des TV-Gerätes 1 und dessen Decodierrechte bzw. Rechte, verschlüsselt übertragene Sendungen decodieren zu dürfen, definieren. Diese Daten können aber auch direkt im Decoder 5 abgespeichert sein.

Zusätzlich übertragen verschiedene Anbieter von Sendebeiträgen, auch mit Diensteanbieter bezeichenbar, weitere digitale Informationen, mit denen der Decoder 5 gezielt aktiviert oder deaktiviert werden kann. Diese Informationen werden als so genannte EMM (Entitled Management Messages) bezeichnet. Einem Kunden bzw. Nutzer eines solchen TV-Gerätes 1 mit einem derartigen Decoder 5 können seitens des TV-Geräte-Herstellers bzw. des Diensteanbieters oder des Rundfunksignalsenderbetreibers mehr oder weniger Rechte für die Entschlüsselung bzw. Decodierung von verschlüsselt übertragenen Sendeinhalten oder Programmbeiträgen zugewiesen werden, ohne dass er hierzu eine weitere Smartcard benötigt. Die Rechte zur Decodierung können somit direkt vom Diensteanbieter verändert werden. So können Uhrzeiten vorgegeben werden, an denen eine Decodierung zugelassen wird und/oder es können Zeiträume für die zulässige Decodierung definiert werden.

Die Anzahl der Rundfunksender, welche mit dem TV-Gerät 1 empfangbar sind, ist abhängig vom Aufstellungsort des TV-Gerätes 1 und der Art des Tuners 2. Die Anzahl der auf dem Bildschirm 6 darstellbaren Sendeinhalten oder Programmbeiträge von Sendern und somit nutzbaren Sendern ist wiederum abhängig von den Rechten des Nutzers, welche zur Decodierung notwendig sind, um verschlüsselt übertragene Sendeinhalte oder Programmbeiträge decodieren zu können.

Es wird daher bei der Erstinbetriebnahme des TV-Gerätes 1 ein Sendersuchlauf vorgenommen, in welchem alle selektiv vom TV-Gerät 1 empfangbaren Sender gesucht und im Senderspeicher 4 abgespeichert werden. Der Senderspeicher 4 ist in Senderspeicherplätze unterteilt. Auf jeden Senderspeicherplatz kann ein Sender gespeichert werden. Hierzu speichert die Mikrocomputereinheit 3 in den Senderspeicher 4 auf einen Senderspeicherplatz die Kenndaten eines Senders, wie z.B. die Kurzbezeichnung, Sendefreuenz usw.

Es kann aber nun vorkommen, dass sich die Kenndaten der bereits gespeicherten Sender ändern. Demnach ist es notwendig, dass das TV-Gerät 1 selbsttätig oder aber auf Anstoß des Nutzers oder aber bei Änderung der Rechte bezüglich des Decoders 5 oder bei Einsatz einer neuen Smartcard in das TV-Gerät 1 in die Lage versetzt wird, neue Sender und/oder Sendeinhalte oder Programmbeiträge, welche zum einen neu übertragen werden oder die dank der neuen Daten und Rechte nunmehr entschlüsselt werden können, auffindet und in den Senderspeicher 4 aufnimmt.

Damit die Liste der Sender bzw. Sendeinhalte oder Programmbeiträge im TV-Gerät 1 aktuell bleibt, wird in regelmäßigen Abständen oder bei Änderungen der Rechte bzgl. der Decodierung selbsttätig und ausgelöst vom TV-Gerät 1 ein Sendersuchlauf vorgenommen. Die Initialisierung dieses Sendersuchlaufs erfolgt entweder über den Betreiber des DVB-Netzes oder über einen Diensteanbieter oder aber über einen Nutzer des TV-Gerätes 1 oder durch das TV-Gerät 1 selbst.

Das TV-Gerät 1 ist nunmehr in verschiedenen Betriebsweisen bezüglich des Sendersuchlaufes betreibbar. In einer ersten Betriebsart werden in Zusammenarbeit der Mikrocomputereinheit 3, des Tuners 2 und des Decoders 5 sämtliche für das TV-Gerät 1 empfangbare Sender gesucht.

Der Sendersuchlauf erfolgt in der Weise, dass in Abhängigkeit der Art des Tuners 2 die für das TV-Gerät 1 empfangbaren Sender, die über den Signaleingang 13 am TV-Gerät 1 bereitgestellt werden, durchsucht werden. Handelt es sich, in vorzugsweiser Ausführung um einen DVB-fähigen Tuner, sprich um einen digital-terrestrischen oder digitalen Satellitenempfangstuner, so werden sämtliche bereitgestellten terrestrischen Frequenzen, wie sämtliche digitalen Satellitenfrequenzen, abgesucht. Kommt ein so genannter Webtuner zum Einsatz, so wird das gesamte Web, wobei dort Listen hinterlegt sind, an welchen Internet-Adressen Sendeinhalte oder Programmbeiträge abrufbar sind, durchsucht.

Im Weiteren wird die Vorgehensweise beim Sendersuchlauf lediglich für DVB-Signale beschrieben. Es kann aber auch jedes andere Übertragungsverfahren verwendet werden, es muss lediglich der Tuner 2 geeignet sein, diese Signale zu empfangen.

Der Tuner 2 tunt in Abstimmung und Steuerung durch die Mikrocomputereinheit 3 sämtliche empfangbaren Frequenzbereiche durch und der Mikrocomputer 3 stimmt den Tuner 2 einzeln und nacheinander auf diese Frequenzen ab. Ist nunmehr auf einer Frequenz ein Signal mit Sendeinhalten vorhanden, so wird dieses Signal empfangen und die Daten zum empfangenen Sender werden im Senderspeicher 4 auf einem Senderspeicherplatz gespeichert. Es werden die Kenndaten zu diesem Sender gespeichert. Anschließend wird die Suche fortgesetzt. Dieser erfolgt so lange, bis die gesamten empfangbaren Frequenzen durchlaufen sind. Im Senderspeicher 4 werden die im Rahmen des Sendersuchlaufs aufgefundenen Sender abgespeichert. Die Abspeicherung erfolgt in einer vorteilhaften Ausgestaltung der Erfindung nacheinander in der Reihenfolge, wie sie aufgefunden werden.

In einer weiteren vorteilhaften Ausgestaltung der Erfindung werden die Sender in der Weise im Senderspeicher 4 sortiert, dass auf den ersten Senderspeicherplätzen diejenigen Sender abgelegt werden, die in der Sprache übertragen werden, die dem Aufstellungsort entsprechen. Alternativ kann die Sprache für die Sender, welche auf den ersten Programmspeicherplätzen gespeichert werden, vom Nutzer vorgegeben werden.

Ist der Suchlauf in der vorbeschriebenen Weise beendet, so werden anschließend die aufgefundenen Sender dahingehend verifiziert und überprüft, ob es sich um frei übertragene Sender bzw. Sendebeiträge handelt, d.h. um sogenannte Free-to-air-Sender, oder ob es sich um verschlüsselt übertragene Sender bzw. Sendeinhalte oder Programmbeiträge handelt.

Als verschlüsselt übertragen erkannte Sender bzw. Sendeinhalte oder Programmbeiträge werden im Senderspeicher 4 mit einer Markierung versehen. Das TV-Gerät 1 kann sodann, vorzugsweise mittels der Mikrocomputereinheit 3, erkennen, ob ein im Senderspeicher 4 auf einen dortigen Senderspeicherplatz gespeicherter Sender bzw. Sendeinhalt oder Programmbeitrag verschlüsselt übertragen wird oder nicht.

Beim Durchsuchen des Sendespeichers 4 ist das TV-Gerät 1 somit in der Lage, verschlüsselt übertragene Sender bzw. Sendeinhalte oder Programmbeiträge anhand der Markierung zu erkennen.

Im Anschluss an einen Sendersuchlauf wird dann in Zusammenarbeit der Mikrocomputereinheit 3 mit dem Decoder 5 analysiert, ob die verschlüsselt übertragenen Sender bzw. Sendeinhalte oder Programmbeiträge von dem Decoder 5 decodierbar sind. Hierzu wird in der vorbeschriebenen Weise anhand der ECMs bzw. der EMMs ermittelt, ob jeder der als verschlüsselt gekennzeichnete Sender mit dem Decoder 5 entschlüsselbar ist. Durch die Verwendung der ECMs bzw. der EMMs ist diese Überprüfung schnell vornehmbar. Es wird mittels des Tuners 2 auf den entsprechenden Sender getunt und die zugehörigen und mitübertragenen ECMs bzw. EMMs werden in der vorbeschriebenen Weise verwendet, um zu prüfen, ob der Sender bzw. Programmbeitrag vom Decoder 5 decodierbar ist.

In einer vorteilhaften Ausgestaltung der Erfindung werden im Senderspeicher 4 zu jedem dort gespeicherten Sender bzw. Sendeinhalt oder Programmbeitrag die zugehörigen ECMs bzw. EMMs abgespeichert. Somit ist bei der vorbeschrieben Vorgehensweise ein Tunen auf einen Sender zur Überprüfung der Decodierbarkeit mit dem Decoder 5 nicht mehr notwendig. Die Überprüfung kann ausschließlich anhand der bereits im Senderspeicher 4 gespeicherten Daten erfolgen.

Ergibt die Überprüfung, dass ein als verschlüsselt übertragener Sender, der im Senderspeicher 4 gespeichert ist, mittels des Decoders 5 decodierbar ist, so wird dieser Sender bzw. Sendeinhalt oder Programmbeitrag als entschlüsselbar markiert. Ergibt hingegen die Überprüfung, dass ein als verschlüsselt übertragen markierter Sender bzw. Sendeinhalt oder Programmbeitrag, der im Senderspeicher 4 gespeichert ist, mittels des Decoders 5 nicht decodierbar ist, wird der Sender bzw. Sendeinhalt oder Programmbeitrag als nicht entschlüsselbar markiert.

Die Markierungen erfolgen in einer vorteilhaften Ausgestaltung der Erfindung, indem zu jedem der im Senderspeicher 4 gespeicherten Sender bzw. Sendeinhalt oder Programmbeitrag ein entsprechendes Flag gesetzt wird.

Sind alle im Senderspeicher 4 gespeicherten Sender bzw. Sendeinhalte oder Programmbeiträge in vorbeschriebener Weise überprüft, ist der Sendersuchlauf beendet.

Das TV-Gerät 1 ist nunmehr in einer weiteren Sendersuchlaufbetriebsart betreibbar. Hierbei werden wiederum sämtliche Frequenzbereiche für Sender in der vorbeschriebenen Weise durchsucht, indem der Tuner 2 das gesamte Frequenzband, welches mit dem Tuner 2 empfangbar ist, durchstimmt und nach empfangbaren Sendern für das TV-Gerät 1 durchsucht.

Wird nunmehr ein Sender gefunden, so werden die Daten des gefundenen Senders von der Mikrocomputereinheit 3 mit den bereits im Senderspeicher 4 abgelegten Senderdaten aller dort gespeicherten Sender verglichen. Ist der neu gefundene Sender bereits im Senderspeicher 4 vorhanden, so werden dessen Daten nicht in den Senderspeicher 4 aufgenommen. Die Suche nach Sendern wird fortgesetzt. Ist der neu gefundene Sender noch nicht im Senderspeicher 4 vorhanden, so werden dessen Daten in den Senderspeicher 4 aufgenommen und die Suche nach Sendern wird fortgesetzt. Ein neu gefundener und in den Senderspeicher 4 aufzunehmender Sender, der nicht bereits im Senderspeicher 4 vorhanden ist, wird an das Ende der bereits im Senderspeicher 4 vorhandenen Sender angefügt. Es wird somit der nächste noch nicht belegte Senderspeicherlatz im Senderspeicher 4 mit den Daten dieses Senders belegt. Nach der Beendigung des Sendersuchlaufs werden die neu in den Senderspeicher 4 aufgenommenen Sender in der zuvor beschriebenen Weise markiert, in Anhängigkeit, ob der Sender verschlüsselt übertragen wird und ob er mit dem Decoder 5 decodierbar ist.

In einer weiteren Betriebsart des TV-Gerätes 1 werden nach Abschluss eines Sendersuchlaufes die im Senderspeicher 4 vorhandenen Sender in einer vom Nutzer vorgebbaren Reihenfolge, beispielsweise der bekannten Anordnung nach der ATS-Euro-Plus-Anordnung, oder einer vom Nutzer vorgebbaren Sortierreihenfolge sortiert.

Ist eine solche Sendersortierung nicht vorgegeben, so sortiert die Mikrocomputereinheit 3 den Senderspeicher 4 in der Weise, dass zunächst alle frei empfangbaren Sender, anschließend alle verschlüsselt übertragenen Sender, welche mit dem Decoder 5 decodierbar sind und zum Schluss alle Sender, die nicht mit dem Decoder 5 decodierbar sind, abgespeichert werden.

In einer alternativen Ausführung der Erfindung speichert die Mikrocomputereinheit 3 im Senderspeicher 4 nur solche Sender, die entweder frei empfangbar sind, d.h. nicht verschlüsselt übertragen werden, oder aber deren Verschlüsselung mit dem Decoder 5 entschlüsselbar sind. Alle anderen Sender werden nicht gespeichert.

In einer weiteren Ausführungsform der Erfindung überprüft die Mikrocomputereinheit 3 zu vorgebbaren Zeiten, vorzugsweise nachts, wenn das TV-Gerät 1 nicht von einem Nutzer verwendet wird, insbesondere im Stand-By-Betrieb, sämtliche im Senderspeicher 4 gespeicherten, als nicht decodierbar markierten Sender und überprüft, ob mit dem Decoder 5 diese Sender decodierbar sind. Auf diese Weise wird die beim Sendersuchlauf vorgenommene Markierung nochmals dahingehend überprüft, ob während des Sendersuchlaufs und der hiermit einhergehenden Überprüfung vielleicht ein Fehler vorlag. Werden hierbei nunmehr Sender im Senderspeicher 4 gefunden, die als nicht decodierbar markiert sind, welche aber mit dem Decoder 5 decodierbar sind, so werden diese Sender entsprechend ummarkiert und ggf. im Senderspeicher 4 in der zuvor beschriebenen Weise umsortiert, d.h. aus der Gruppe der nicht decodierbaren Sender in die Gruppe der decodierbaren Sender umsortiert. Dies gilt gleichermaßen auch im umgekehrten Fall: Sender, die fälschlicherweise als decodierbar eingestuft wurden, obwohl sie nicht zu decodieren sind, werden entsprechend gekennzeichnet.

In einer weiteren Ausgestaltung der Erfindung ist vorgesehen, dass, sobald die Mikrocomputereinheit 3 erkennt, dass im TV-Gerät 1 eine weitere oder neue Smartcard eingesetzt worden ist oder aber der Decoder 5 neue Decodier-bzw. Nutzungsrechte erhalten hat, das TV-Gerät 1 einen Sendersuchlauf startet. Beim Sendersuchlauf wird in der vorbeschriebenen Wiese vorgegangen. In vorzugsweiser Ausführung der Erfindung bleibt die Belegung des Senderspeichers 4 im Hinblick auf bereits gespeicherte Sender unverändert. Der Nutzer kann aber über einstellbare Voreinstellungen diese Vorgehensweise verändern.

Es werden nur neu gefundene Sender abgespeichert, die bisher nicht im Senderspeicher 4 vorhanden waren. Allerdings werden die als nicht decodierbar markierten Sender in vorbeschriebener Weise überprüft und deren Markierung verändert, wenn diese Sender aufgrund der Änderungen nunmehr vom Decoder 5 decodierbar sind.

In einer weiteren Ausgestaltung der Erfindung überprüft die Mikrocomputereinheit 3, sobald diese erkennt, dass im TV-Gerät 1 eine weitere oder neue Smartcard eingesetzt worden ist oder aber der Decoder 5 neue Decodier- bzw. Nutzungsrechte erhalten hat, nur die bereits im Senderspeicher 4 gespeicherten Sender, welche mit nicht decodierbar gekennzeichnet sind, und überprüft in der vorbeschriebenen Weise, ob einer oder mehrere dieser Sender durch die neuen Nutzungsrechte nunmehr von dem Decoder 5 decodierbar sind. Ist dies der Fall, erfolgt eine Ummarkierung und Umgruppierung dieses bzw. dieser Sender im Senderspeicher 4. In analoger Weise werden sodann die als decodierbar markierten Sender des Senderspeichers 4 überprüft um festzustellen, ob sich ggf. bei diesen Sendern ebenfalls Änderungen ergeben haben.

In einer weiteren Ausgestaltung der Erfindung ist vorgesehen, dass die Mikrocomputereinheit 3 in regelmäßigen Abständen, welche vom Nutzer einstellbar und vorgebbar sind, einen automatischen Sendersuchlauf vornimmt. Hierdurch werden dann neue Sender erkannt bzw. Sender, bei denen sich die Codierung verändert hat, erkannt und entsprechend gespeichert.

Wird nunmehr ein bereits im Senderspeicher 4 gespeicherter Sender gefunden, so wird überprüft, ob der gefundene Sender mit dem Decoder 5 decodierbar ist. Ist der Sender decodierbar und ist er im Senderspeicher 4 als entschlüsselbar abgespeichert, so werden die Daten des bereits gespeicherten Senders mit den Daten des neu gefundenen Senders verglichen, bei Übereinstimmung der Daten wird nichts verändert. Liegt keine Übereinstimmung vor, so werden die Daten des neu gefundenen Senders zunächst zwischengespeichert. Anschließend nimmt die Mikrocomputereinheit 3 eine Qualitätsprüfung beider Sender vor, indem die Mikrocomputereinheit 3 den Tuner 2 zunächst auf den neu gefundenen Sender abstimmt und das Eingangssignal einer Qualitätsprüfung unterzieht, wobei z.B. der Signalempfangspegel zur Beurteilung herangezogen wird. Anschließend lässt die Mikrocomputereinheit 3 den Tuner 2 auf den im Senderspeicher 4 abgespeicherten Sender abstimmen und unterzieht diesen Sender ebenfalls der Qualitätsprüfung. Ergibt die Qualitätsprüfung, dass der bereits im Senderspeicher 4 abgespeicherte Sender eine bessere Qualität aufweist als der zwischengespeicherte Sender, werden die Daten das zwischengespeicherten Senders gelöscht, andernfalls werden die Daten des bereits im Senderspeicher 4 gespeicherten Senders mit den Daten des zwischengespeicherten Senders überschrieben.

Als Qualitätsprüfung kommt auch eine Beurteilung des Bilddarstellungsinhalts in Betracht, so z.B. eine Beurteilung der Bildfehlerrate der Übertragung.

Wird ein Sender während des Sendersuchlaufs gefunden, der bereits im Senderspeicher 4 abgespeichert ist aber als nicht entschlüsselbar markiert ist, so wird dieser Sender zunächst zwischengespeichert. Das TV-Gerät 1 versucht mittels des Decoders 5 das Sendesignal zu decodieren. Kann der Decoder 5 das Sendesignal decodieren, so wird der neu gefundene Sender im Senderspeicher 4 mit der Markierung entschlüsselbar gespeichert. Der bereits im Senderspeicher gespeicherte gleiche Sender, d.h. der Sender, der die gleiche Senderbezeichnung trägt aber als nicht decodierbar markiert ist, wird aus dem Senderspeicher 4 gelöscht.

Der Nutzer des TV-Gerätes 1 bedient dieses üblicherweise über die Fernbedienung 8. Im TV-Gerät 1 ist daher ein Fernbedienungssignalempfänger 9 angeordnet, der die Bedienbefehle des Nutzers, der diese über die Fernbedienung 8 eingibt, decodiert, umsetzt und an die Mikrocomputereinheit 3 leitet, welche dann diese Bedienbefehle umsetzt und ausführt.

Der Nutzer kann sich eine Liste der im Senderspeicher 4 gespeicherten Sender auf dem Bildschirm 6 darstellen lassen. Bei der Darstellung der Sender auf dem Bildschirm 6 werden diese Sender mit Kurzbezeichnungen, wie beispielsweise ARD, ZDF, SAT1, und weiteren Hinweisen über die Übertragungsart dargestellt. Zusätzlich ist eine Markierung hinter jedem Sender darstellbar, welche einem Nutzer signalisiert, ob der betreffende Sender unverschlüsselt oder verschlüsselt übertragen wird. Im Weiteren kann der Nutzer anhand der Markierung erkennen, ob der Decoder 5 einen als verschlüsselt markierten Sender decodieren kann oder nicht. Zur besseren Übersichtigkeit und Darstellung erfolgt die Darstellung der Sender des Senderspeichers 4 listenmäßig.

In einer vorteilhaften Ausgestaltung der Erfindung werden alternativ nur die frei empfangbaren, d.h. unverschlüsselten Sender und/oder die Sender, die das TV-Gerät 1 mit dem Decoder 5 entschlüsseln kann, dargestellt. Die nicht entschlüsselbaren Sender werden nicht dargestellt.

Die Darstellung von Sendeinhalten oder Programmbeiträgen erfolgt über die Darstellungsaufbereitungseinheit 11. Diese bereitet die Daten der Sendeinhalte oder Programmbeiträge zur Darstellung auf dem Bildschirm 6 auf.

In einer weiteren Ausgestaltung der Erfindung sind die nicht entschlüsselbaren Sender entsprechend mit einer Markierung versehen, welche vorzugsweise in Form eines Schlosses dargestellt sind. Ist das Schloss verschlossen dargestellt, ist der Sender nicht mit dem Decoder 5 decodierbar, ist das Schloss geöffnet dargestellt, ist der Sender mit dem Decoder 5 entschlüsselbar. Unverschlüsselte Sender sind mit keinem Schloss markiert.

Außerdem ist eine OSD-Einheit 10 vorgesehen, mittels derer Zeichen auf dem Bildschirm 6 darstellbar sind.

### Bezugszeichenliste

- 1: TV-Gerät
- 2: Tuner
- 3: Mikrocomputer
- 4: Senderspeicher
- 5: Decoder
- 6: Bildschirm
- 7: HF-Signaleingang
- 8: Fernbedienung
- 9: Fernbedienungsempfänger
- 10: On-Screen-Display-Einheit
- 11: Darstellungsaufbereitungseinheit
- 12: Satellitenantenne
- 13: Eingang

## Patentansprüche

1. Rundfunksignalempfangsgerät (1) mit mindestens einer Empfangseinheit (2) und mindestens einer Steuereinheit (3), wobei das Rundfunksignalempfangsgerät (1) mittels der Steuereinheit (3) in mindestens zwei Sendersuchlaufbetriebsarten betreibbar ist,
wobei das Rundfunksignalempfangsgerät (1) so ausgebildet ist, dass in der ersten Sendersuchlaufbetriebsart automa¬tisch nacheinander alle selektiv vom Rundfunksignalemp¬fangsgerät (1) empfangbaren verschlüsselten und unver¬ischlüsselten Rundfunksignalsen¬der mittels der mindestens einen Empfangseinheit (2), steuerbar von der mindestens einen Steuereinheit (3), ab¬suchbar sind und Daten über alle verschlüsselten und unver¬schlüsselten vom Rundfunksignalempfangsgerät(1) empfang¬baren Rundfunksignal¬sender in einen Senderspeicher (4) des Rundfunksignalemp¬fangsgeräts (1) abspeicherbar sind,
wobei das Rundfunksignalempfangsgerät (1) so ausgebildet ist, dass in der mindestens zweiten Sendersuchlaufbe¬triebsart automatisch nachein¬ander alle selektiv von dem Rundfunksignalempfangsgerät (1) empfangbaren verschlüs¬selten und unverschlüsselten Rundfunksignalsender mittels der mindestens einen Emp¬fangseinheit (2), steuerbar von der mindestens einen Steuereinheit (3), absuchbar sind und Daten über alle verschlüs¬selten und unverschlüsselten vom Rundfunksignalempfangs¬gerät(1) empfangbaren Rundfunksignalsender mit den be¬reits im Senderspeicher (4) gespeicherten Rundfunksignal¬sendern vergleichbar und nur nicht bereits im Senderspei¬cher (4) vorhandene Rundfunk¬signalsender nach dem letzt¬belegten Senderspeicherplatz im Senderspeicher (4) ein¬speicherbar sind und
wobei das Rundfunksignalempfangsgerät (1) mindestens ei¬nen Decoder (5) der vom Rundfunksignalsender verschlüsselt übertragenen In¬formationen aufweist, wobei das Rundfunkempfangsgerät so ausgebildet ist, dass bei der ersten und der mindestens zweiten Sendersuchlauf¬betriebsart durch das über die Steuereinheit (3) steu¬erbare Rundfunksignalempfangsgerät (1) beim Auffinden eines ver-schlüsselten Rundfunksignalsenders die vom Rund¬funksig-nalsender übertragenen Informationen mittels des mindes¬tens einen Decoders (5) dahingehend untersuchbar sind, ob diese vom min¬destens einen Decoder (5) decodierbar sind, wobei das Rundfunksignalempfangsgerät (1) so ausgebildet ist, dass hierzu Zusatzdaten verwend¬bar sind, die vom Rundfunksignalsender mit übertragen werden, und das Rundfunksignalempfangs¬gerät (1) so ausge¬bildet ist, und wobei bei erfolgreicher Decodierung die im Senderspeicher (4) gespeicherten Daten zum Rundfunksignalsender unverändert belassen werden und
bei erfolgloser Dekodierung dieser Rundfunksignalsender durch das Rundfunksignalempfangsgerät (1) im Senderspei¬cher (4) als nicht entschlüsselbar markierbar oder dieser Rundfunksignalsender aus dem Senderspeicher (4) löschbar ist.

2. Rundfunksignalempfangsgerät nach Patentanspruch 1, **dadurch gekennzeichnet, dass** das Rundfunksignalempfangsgerät (1) so ausgebildet ist, dass mittels der Steuereinheit (3) und des mindestens einen Decoders (5) zur Decodierung die Überprüfung der Ent¬schlüs¬selbarkeit der vom Rundfunksig¬nalsender übertrage¬nen In¬formationen erst nach Beendigung eines Sendersuch¬laufs vornehmbar ist.

3. Rundfunksignalempfangsgerät nach Patentanspruch 1, **dadurch gekennzeichnet, dass** auf einer dem Rundfunksignalempfangsgerät (1) zugeordneten Darstellungseinheit (6) die im Senderspeicher (4) gespeicherten Rundfunksignalsender in Form einer Rundfunksignalsender¬liste darstellbar sind und die nicht als entschlüsselbar markierten Rundfunksignalsender mit einer entsprechenden Markierung versehen darstellbar sind oder die als nicht entschlüsselbar markierten Rundfunksignalsender nicht in der Senderliste darstellbar sind.

4. Rundfunksignalempfangsgerät nach einem der vorangehen¬den Patentansprüche, **dadurch gekennzeichnet, dass** das Rundfunksignalempfangsgerät (1) so ausgebildet ist, dass mittels der Steuereinheit (3) die als nicht entschlüsselbar markier¬ten Rundfunksignalsender am Ende der Senderliste dar-stellbar sind und/oder der Senderspei¬cher (4) in der Weise sor¬tierbar ist, dass die als nicht entschlüsselbar markierten Rundfunksignalsender nach den nicht verschlüsselten oder als entschlüsselbar markierten Rundfunksignalsendern an¬gefügt sind.

5. Rundfunksignalempfangsgerät nach einem der vorangehen¬den Patentansprüche, **dadurch gekennzeichnet, dass** das Rundfunksignalempfangsgerät (1) so ausgebildet ist, dass bei Erkennung einer Veränderung am Decoder (5) oder bei Erkennung von Änderungen der Decodie¬rungsrechte des Decoders (5) zur Decodierung oder bei Er¬kennen eines Einbaus oder neuen Vorhandenseins eines wei¬teren Decoders (5) zur Deco¬dierung ein Sender¬suchlauf startbar ist.

6. Rundfunksignalempfangsgerät nach einem der vorangehen¬den Patentansprüche 1 bis 4, dadurch gekenn¬zeichnet, dass das Rundfunksignalempfangsgerät (1) so ausgebildet ist, dass das Rundfunksignalempfangs¬gerät (1) bei Erkennung einer Veränderung am Decoder (5) zur Decodierung oder bei Er¬ken¬nung von Änderungen der Decodierungsrechte des Deco¬ders (5) zur Decodierung oder bei Erkennen eines Einbaus oder Vorhandenseins eines wei¬teren Decoders (5) Deco¬dierung alle bereits im Senderspeicher (4) gespei¬cherten und verschlüsselt und/oder als nicht entschlüs¬selbar mar¬kierten Rundfunksignalsender erneut versucht zu dekodie¬ren und in Abhängigkeit des Ergebnisses des Deko¬dierver¬suchs die Markierung der Rundfunksignalsender un¬verändert belässt oder verändert.

7. Rundfunksignalempfangsgerät nach einem der vorangehen¬den Patentansprüche, **dadurch gekennzeichnet, dass** das Rundfunksignalempfangsgerät (1) so ausgebildet ist, dass das Rundfunksignalempfangs¬gerät (1) zur Erken¬nung, ob Informationen, die von einem verschlüsselt über¬trage¬nen Rundfunksignalsender übertragen werden, von dem Deco¬der (5) zur Decodie¬rung entschlüsselbar sind, die vom Rundfunksignalsender bereitgestellte Zusatzdaten verwendet.

8. Rundfunksignalempfangsgerät nach einem der vorangehen¬den Patentansprüche, **dadurch gekennzeichnet, dass** der Decoder (5) ein embedded Conditional-Access-Modul umfasst.

9. Rundfunksignalempfangsgerät nach Patentanspruch 8, **dadurch gekennzeichnet, dass** das Common-Inter¬face-Conditional-Access-Modul zur Entschlüsselung der verschlüsselt übertragenen Informa¬tionen eines Rund¬funksignalsenders, mit einer in das Rundfunksig¬nalempfangsgerät (1) über einen Eingabeschacht einfügba¬ren Smartcard kommuniziert und/oder dass die Überprüfung der Entschlüsselbarkeit der von einem Rundfunksignalsen¬der übertragenen Informationen zu einer vom Benutzer des Rundfunksignalempfangsgeräts (1) über ein Menü, darstell¬bar am Bildschirm (5) des Rundfunksignalempfangsgeräts (1), einstellbaren Zeit durchführbar ist und/oder die Überprüfung der Entschlüs¬selbarkeit der von einem Rundfunksignalsen¬der übertrage¬nen Informationen vorzugsweise während des Nichtbetriebes des Rundfunksignalempfangsgeräts durch ei¬nen Nutzer durchführbar ist.

## Claims

1. Broadcast signal receiver (1) with at least one receiving unit (2) and at least one control unit (3), wherein the broadcast signal receiver (1) is operable by means of the control unit (3) in at least two transmitter search operating modes,
wherein the broadcast signal receiver (1) is so constructed that in the first transmitter search operating mode all coded and uncoded broadcast signal transmitters selectively receivable by the broadcast signal receiver (1) are searchable automatically in succession by means of the at least one receiving unit (2) - controllably by the at least one control unit (3) - and data relating to all coded and uncoded broadcast signal transmitters receivable by the broadcast signal receiver (1) are storable in a transmitter memory (4) of the broadcast signal receiver (1),
wherein the broadcast signal receiver (1) is so constructed that in the at least second transmitter search operating mode all coded and uncoded broadcast signal transmitters selectively receivable by the broadcast signal receiver (1) are automatically searchable in succession by means of the at least one receiving unit (2) - controllably by the at least one control unit (3) - and data relating to all coded and uncoded broadcast signal transmitters receivable by the broadcast signal receiver (1) can be compared with the broadcast signal transmitters already stored in the transmitter memory (4) and only broadcast signal transmitters not already present in the transmitter memory (4) can be stored in the transmitter memory (4) after the last-occupied transmitter memory position and
wherein the broadcast signal receiver (1) comprises at least one decoder (5) of the information transmitted in coded form by the broadcast signal transmitter,
wherein the broadcast receiver is so constructed that in the first and the at least second transmitter search operating mode by the broadcast signal receiver (1), which is controllable by way of the control unit (3), in the case of discovery of a coded broadcast signal transmitter the information transmitted by the broadcast signal transmitter can be investigated by means of the at least one decoder (5) with regard to whether this information can be decoded by the at least one decoder (5), wherein the broadcast signal receiver (1) is so constructed that use can be made for that purpose of additional data conjunctively transmitted by the broadcast signal transmitter,
and wherein in the case of successful decoding the data, which are stored in the transmitter memory (4), with respect to the broadcast signal transmitter are left unchanged and in the case of unsuccessful decoding this broadcast signal transmitter can be marked by the broadcast signal receiver (1) in the transmitter memory (4) as non-decodable or this broadcast signal transmitter can be deleted from the transmitter memory (4).

2. Broadcast signal receiver according to claim 1, **characterised in that** the broadcast signal receiver (1) is so constructed that the investigation of the decodability of the information transmitted by the broadcast signal transmitter can be undertaken by means of the control unit (3) and the at least one decoder (5) for the decoding only after the end of a transmitter search.

3. Broadcast signal receiver according to claim 1, **characterised in that** the broadcast signal transmitter stored in the transmitter memory (4) can be represented in the form of a broadcast signal transmitter list on a display unit (6) associated with the broadcast signal receiver (1) and the broadcast signal transmitters marked as non-decodable can be displayed provided with an appropriate marking or the broadcast signal transmitters marked as non-decodable are not displayed in the transmitter list.

4. Broadcast signal receiver according to any one of the preceding claims, **characterised in that** the broadcast signal receiver (1) is so constructed that by means of the control unit (3) the broadcast signal transmitters marked as non-decodable can be displayed at the end of the transmitter list and/or the transmitter memory (4) can be compiled in such a way that the broadcast signal transmitters marked as non-decodable are attached after the non-decoded broadcast signal transmitters or the broadcast signal transmitters marked as decodable.

5. Broadcast signal receiver according to any one of the preceding claims, **characterised in that** the broadcast signal receiver (1) is so constructed that a transmitter search can be started in the case of recognition of a change at the decoder (5) or in the case of recognition of changes of the decoding rules of the decoder (5) for the decoding or in the case of recognition of installation or new presence of a further decoder (5) for the decoding.

6. Broadcast signal receiver according to any one of the preceding claims 1 to 4, **characterised in that** the broadcast signal receiver (1) is so constructed that the broadcast signal receiver (1), in the case of recognition of a change at the decoder (5) for the decoding or in the case of recognition of changes of the decoding rules of the decoder (5) for the decoding or in the case of recognition of installation or presence of a further decoder (5) for the decoding, attempts again to decode all broadcast signal transmitters already stored in the transmitter memory (4) and coded and/or marked as non-decodable and leaves unchanged or changes the marking of the broadcast signal transmitters depending on the result of the decoding attempt.

7. Broadcast signal receiver according to any one of the preceding claims, **characterised in that** the broadcast signal receiver (1) is so constructed that the broadcast receiver (1) uses the additional data, which are provided by the broadcast signal transmitter, for recognition whether information transmitted by a broadcast signal transmitter transmitting in coded form are decodable by the decoder (5) for the decoding.

8. Broadcast signal receiver according to any one of the preceding claims, **characterised in that** the decoder (5) comprises an embedded conditional access module.

9. Broadcast signal receiver according to claim 8, **characterised in that** the common interface conditional access module for the decoding of the information, which has been transmitted in coded form, of a broadcast signal transmitter communicate with a smartcard insertable into the broadcast signal receiver (1) by way of an input shaft and/or that the investigation of the decodability of the information transmitted by a broadcast signal transmitter can be carried out at a time settable by the user of the broadcast signal receiver (1) by way of a menu able to be displayed on the display screen (5) of the broadcast signal receiver (1) and/or the investigation of the decodability of the information transmitted by a broadcast signal transmitter can be carried out by a user preferably during non-operation of the broadcast signal receiver.

## Revendications

1. Dispositif de réception de signaux de radiodiffusion (1) équipé d'au moins une unité de réception (2) et d'au moins un module de commande (3), le dispositif de réception de signaux de radiodiffusion (1) pouvant être exploité sous au moins deux modes de fonctionnement de recherche de chaînes, à travers le module de commande (3),
le dispositif de réception de signaux de radiodiffusion (1) étant configuré pour pouvoir rechercher lors du premier mode de recherche de chaîne, automatiquement et de façon sélective, tous les émetteurs de signaux radio cryptés et non cryptés accessibles au dispositif de réception de signaux de radiodiffusion (1) à travers au moins une unité de réception (2) gérable par au moins un module de commande (3), et que les données cryptées et non cryptées qui peuvent être reçues par le dispositif de réception de signaux de radiodiffusion(1) puissent être sauvegardées dans une mémoire de chaîne (4) du dispositif de réception de signaux de radiodiffusion (1),
le dispositif de réception de signaux de radiodiffusion (1) étant configuré pour pouvoir rechercher, automatiquement et de façon sélective, au moins lors du deuxième mode de fonctionnement de recherche de chaînes, tous les émetteurs de signaux radio cryptés et non cryptés accessibles au dispositif de réception de signaux de radiodiffusion (1) au moyen d'au moins une unité de réception (2) contrôlable par au moins un module de commande (3), et les données pouvant être comparées aux signaux de radiodiffusion déjà sauvegardées dans une mémoire de chaîne (4) et pas tout simplement aux signaux de radiodiffusion déjà disponibles dans la mémoire de chaîne (4) selon le principe de la pré-sélection de chaînes occupée en dernier et
le dispositif de réception de signaux de radiodiffusion (1) disposant d'au moins un décodeur (5) qui comporte des informations cryptées transmises par les émetteurs de signaux radio.
Illisible
le dispositif de réception de signaux de radiodiffusion (1) étant configuré tel que, lors du premier et au moins lors du deuxième mode de recherche de chaîne par le dispositif de réception de signaux de radiodiffusion (1) contrôlable à partir du module de commande (3), pour trouver un émetteur de signaux radio crypté, les informations transmises provenant de l'émetteur de signaux de radiodiffusion puissent être examinées ne serait-ce que par le décodeur (5) pour voir si elles sont décodables par le ou les décodeurs,
le dispositif de réception de signaux de radiodiffusion (1) étant configuré tel que les données supplémentaires puissent être utilisables et puissent être transmises par les émetteurs de signaux de radiodiffusion et le dispositif de réception de signaux de radiodiffusion (1) étant configuré tel que,
illissible
en cas de décodage réussi, les données sauvegardées dans la mémoire de l'émetteur (4) des émetteurs de signaux de radiodiffusion puissent être laissées inchangées et en cas d'échec de décodage de cet émetteur de signaux de radiodiffusion, que celles-ci puissent être stockées dans la mémoire de l'émetteur (4) des émetteurs de signaux de radiodiffusion en tant que non-décryptables ou alors que l'émetteur de signaux de radiodiffusion en question puisse être effacé de la mémoire de l'émetteur (4).

2. Dispositif de réception de signaux de radiodiffusion selon la revendication 1, **caractérisé par le fait que** le dispositif de réception de signaux de radiodiffusion (1) est configuré de telle sorte qu'au moyen de l'unité de commande (3) et d'au moins un décodeur (5), pour pouvoir décoder, la vérification de la décryptabilité des informations transmises par l'émetteur de signaux radio n'est possible qu'à la fin d'une recherche de chaîne.

3. Dispositif de réception de signaux de radiodiffusion selon la revendication 1, **caractérisé par le fait que** dans l'une des unités d'affichage (6) du dispositif de réception de radiodiffusion (1) les émetteurs de signaux de radio stockés dans la mémoire d'émission (4) peuvent être affichés sous la forme d'une liste d'émission de signaux de diffusion et les émetteurs de signaux radio marqués comme non-déchiffrables sont affichables avec la balise correspondante ou alors les émetteurs de signaux de radiodiffusion marqués comme non-déchiffrables ne sont pas affichables sur la liste de diffusion.

4. Dispositif de réception de signaux de radiodiffusion selon l'une des revendications précédentes **caractérisé par le fait que** le dispositif de réception de signaux radio (1) est configuré tel qu'au moyen du module de commande (3), les émetteurs de signaux radio non-déchiffrables sélectionnés puissent être affichés à la fin de la liste de canaux et / ou alors la mémoire de l'émetteur (4) puisse être triée de manière à ce que les émetteurs de signaux radio marqués non décryptables soient ajoutés à la suite des émetteurs de signaux radio marqués comme non-déchiffrables ou ceux étiquetés comme décryptables.

5. Dispositif de réception de signaux radio selon l'une des revendications précédentes **caractérisé en ce que** le dispositif de réception de signaux de radio (1) est formé de telle sorte que lors de la détection d'un changement au niveau du décodeur (5) ou lors de la détection de modifications dans les droits de décodage du décodeur (5) à décoder ou lors de la détection d'une installation ou la présence d'un nouveau décodeur (5) une recherche de station soit amorçable pour le décodage.

6. Dispositif de réception de signaux radio selon l'une des revendications 1 à 4 **caractérisé par le fait que** le dispositif de réception de signaux de radio (1) est configuré de telle sorte que le dispositif de réception de signaux de radio (1) lors de la détection d'un changement au niveau du décodeur (5) lors du décodage ou lors de la détection des modifications des droits de décodage du décodeur (5) en vue du décodage ou en cas de détection d'une installation ou de la présence d'un décodeur supplémentaire (5) lance une nouvelle tentative pour décoder tous les émetteurs de signaux radio de décodage déjà stockés dans la mémoire de l'émetteur (4) et cryptés et /ou marqué comme indéchiffrables, et, en fonction du résultat de la tentative de décodage, laisse inchangé ou alors modifie le marquage de l'émetteur de signal radio.

7. Dispositif de réception de signaux radio selon l'une des revendications précédentes **caractérisé par le fait que** le dispositif de réception de signaux radio (1) est configuré de telle sorte que le dispositif de réception de signaux radio (1) pour reconnaître si des informations transmises à partir d'un émetteur de signal radio crypté et pouvant être décryptées par le décodeur (5) sont effectivement transmises, utilise les données supplémentaires fournies par l'émetteur de signal de diffusion.

8. Dispositif de réception de signaux de radio selon l'une des revendications précédentes **caractérisé par le fait que** le décodeur (5) comprend un module d'accès conditionnel intégré.

9. Dispositif de réception de signaux de radiodiffusion selon la revendication 8 **caractérisé par le fait que** la « Common-Interface-conditional-Access-Modul » (l'interface du module d'accès conditionnel), pour décrypter les informations cryptées transmises par un émetteur de signaux de radio, communique avec une carte à puce insérable dans le dispositif de réception de signaux de radio (1) par l'intermédiaire d'un arbre d'entrée et / ou encore **caractérisé par le fait qu'**il est possible de réaliser la vérification de la décryptabilité des informations émises par l'émetteur de signaux de radio à un utilisateur du dispositif de réception du signal radio (1) affichable à l'écran (5) du dispositif de réception de signaux de radio (1) via un menu, la période de temps étant réglable et/ou encore **caractérisé par le fait que** l'examen de la décryptabilité des informations transmises par l'émetteur de signaux radio peut être réalisé par un utilisateur, de préférence lorsque le dispositif de réception de signaux radio n'est pas en marche.
